# EUROPÄISCHE PATENTSCHRIFT

(11) **EP 2 309 521 B1**
(45) Veröffentlichungstag und Bekanntmachung des Hinweises auf die Patenterteilung: **27.02.2013**
(21) Anmeldenummer: 09171375.0
(22) Anmeldetag: 25.09.2009
(51) Int. Cl.: H01C 1/16, H05K 1/00, H05K 1/02, H05K 3/00, H05K 1/16, H05K 1/14

(54) **Widerstandsbaugruppe**
Resistance component
Bloc de résistance

(43) Veröffentlichungstag der Anmeldung: 13.04.2011
(73) Patentinhaber: Arcus Elektrotechnik Alois Schiffmann GmbH, 81673 München (DE)
(72) Erfinder: Wild, Manuel, 81673 München (DE); Lasinger, Fritz, 81673 München (DE)
(74) Vertreter: Sajda, Wolf E.

(56) Entgegenhaltungen:
- WO-A1-2004/081589
- FR-A1- 2 267 616
- US-A- 2 962 685
- US-A- 3 541 491
- US-A- 5 521 576
- US-A1- 2004 001 325
- US-A1- 2006 012 382

## Beschreibung

Die Erfindung betrifft eine Widerstandsbaugruppe, die beispielsweise für Meßzwecke bei Mittelspannungs- oder Hochspannungsanwendungen geeignet ist. Dabei handelt es sich in der Regel um hochohmige Widerstände in der Größenordnung von einigen Hundert MOhm.

Derartige Widerstände werden herkömmlicherweise unter Verwendung von Leiterplatten hergestellt, auf denen eine Vielzahl von einzelnen Widerstandselementen angebracht, insbesondere angelötet werden. Zu diesem Zweck sind die Leitungsplatinen herkömmlicherweise mit einem Leitungsmuster mit Lötaugen versehen, in denen die jeweiligen einzelnen Widerstände in THT-Technik eingesteckt und angelötet werden.

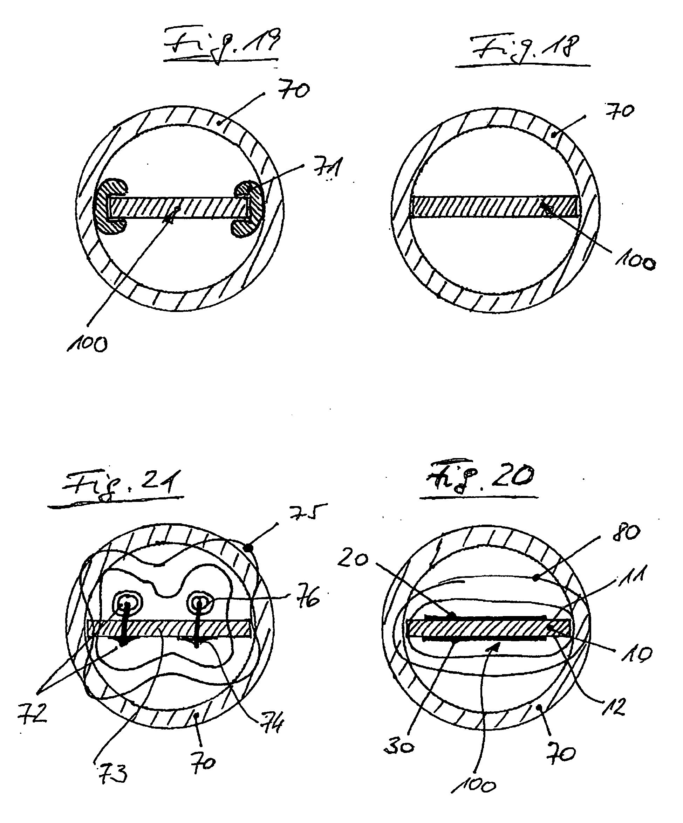

In Fig. 21 ist schematisch ein Querschnitt durch eine herkömmliche Meßeinrichtung mit einer derartigen Widerstandsbaugruppe dargestellt. In einem Trägerrohr 70 ist eine Trägerplatine 73 angeordnet, die ein Widerstandselement 76 im Schnitt zeigt, das mit seinen Anschlußbeinen 72 und Lötungen 74 an der Trägerplatine 73 befestigt ist. Bei einer derartigen Anordnung ergeben sich üblicherweise sehr inhomogene elektrische Felder mit Feldspitzen, die schematisch bei 75 in Fig. 21 angedeutet sind.

Derartige herkömmliche Widerstandsbaugruppen sind relativ aufwendig in der Herstellung, da die einzelnen Widerstandselemente eingesetzt und eingelötet werden müssen. Auch sind die einzelnen Widerstandselemente naturgemäß nicht alle in identischer Weise über die Länge des Trägers montiert. Daher kommt es zwangsläufig zu sehr inhomogenen Feldern, insbesondere bedingt durch die an den Anschlußbeinen hervorgerufenen Spannungsspitzen. Diese Aspekte führen in der Praxis dazu, daß die herkömmlichen Widerstandsplatinen nur bis zu bestimmten Spannungswerten eingesetzt werden können.

Aus der US-A-5 521 576 sind elektrische Widerstände und Widerstandsnetzwerke bekannt, bei denen ein Gesamtwiderstand auf einem Substrat ausgebildet ist und eine Vielzahl von Widerstandsgruppen zwischen Anschlussbereichen vorgesehen sind. Dabei können eine Vielzahl von solchen Widerstandsgruppen und Anschlussbereichen auf einem Substrat vorgesehen sein, wobei sich die hintereinander liegenden Serienschaltungen von Widerständen mit einer entsprechenden Serie von Widerständen in der nächsten, geometrisch parallel dazu angeordneten Reihe verbinden lassen. Auch zickzackförmige Reihenschaltungen aus einer Vielzahl von derartigen Widerständen sind möglich. Die jeweiligen Widerstandsgruppen, die sich zu einem gewünschten Gesamtwiderstand konfigurieren lassen, sind dabei lediglich auf einer Oberfläche eines Substrats ausgebildet, sodass die Einsatzmöglichkeiten limitiert sind.

In der US-A-3 541 491 sind elektrische Widerstandsanordnungen beschrieben, bei denen mäanderförmige Widerstandselemente verwendet werden. Die Widerstandswerte der einzelnen Bereiche können unterschiedlich vorgegeben werden, beispielsweise durch Auswahl der Höhe und der Breite der mäanderförmigen Bahnen. Aus der US-A-3 541 491 ist es weiterhin bekannt, die Widerstandsanordnung in einer gewünschten Weise zu trimmen und Feinabstimmungen vorzunehmen, indem man vorhandene Brücken oder Streifen durchtrennt, um auf diese Weise Reihenschaltungen von Widerständen mit unterschiedlichen Längen und Widerstandswerten zu realisieren. Die Widerstandselemente sind dabei lediglich auf einer Seite eines Substrats ausgebildet.

Aus der FR-A-2 267 616 sind abgleichbare elektrische Bauelemente bekannt, wobei auf einem Trägerkörper Schichtwiderstände ausgebildet sind, die zwischen zwei Anschlüssen und anschließenden Leitungsbahnen in Serie geschaltet sind. Bei einer Ausführungsform ist jeder Widerstand durch eine Nebenschlußschleife kurzgeschlossen, die sich über eine Kerbe in einem Zahn einer Zahnung erstreckt. Bei den Bauelementen gemäß der FR-A-2 267 616 besitzt der Trägerkörper beispielsweise zwei, gemäß einer geometrischen Reihe gestufte Widerstände, die zwischen Anschlüssen in Serie geschaltet sind. Die Umrisslinie des Trägerkörpers ist wiederum auf zwei gegenüberliegenden Seiten gezahnt, wobei jeder Widerstand eine Nebenschlußschleife besitzt, die sich über die Kerbe an der Basis der Zahnung in einen Zahn erstreckt. Die einzelnen Zähne sind durch Schlitze voneinander getrennt. Der Abgleich bzw. das Einstellen eines bestimmten Widerstandswertes erfolgt bei dieser herkömmlichen Konstruktion dadurch, dass ein Zahn oder mehrere Zähne entlang einer Kerbe an der Basis der Zahnung abgebrochen werden, sodass der dem abgebrochenen Zahn zugeordnete Widerstand eingeschaltet wird.

In der W02004/081589 A1 ist ein Hochspannungs-Teiler-Netzwerk beschrieben, welches aus einer Serienschaltung von individuellen Widerstandselementen aufgebaut ist. Ferner ist dort eine Serienschaltung von Abschirmwiderständen vorgesehen, die eine zylindrische Abschirmung bilden. Die gesamte herkömmliche Anordnung bildet dabei einen langgestreckten zylindrischen Hochspannungswiderstand.

Der Erfindung liegt die Aufgabe zugrunde, eine Widerstandsbaugruppe anzugeben, die sich mit verringertem Herstellungsaufwand herstellen und an die Anforderungen der Praxis in vielseitiger Weise anpassen lässt.

Zur Lösung dieser Aufgabe wird gemäß der Erfindung eine Widerstandsbaugruppe angegeben, die folgendes aufweist:
einen isolierenden, langgestreckten Träger mit zwei einander gegenüberliegenden Hauptflächen, die eine Oberseite und eine Unterseite des Trägers bilden;
eine auf der einen Hauptfläche des Trägers vorgesehene erste Widerstandsanordnung, die sich über die Länge des Trägers erstreckt;
eine auf der anderen, gegenüberliegenden Hauptfläche des Trägers vorgesehene zweite Widerstandsanordnung, die sich über die Länge des Trägers erstreckt;
wobei die Widerstandsbaugruppe aus einer Vielzahl von Modulen aufgebaut ist, die integral miteinander ausgebildet sind, jeweils miteinander verbundene Teile der ersten Widerstandsanordnung und miteinander verbundene Teile der zweiten Widerstandsanordnung tragen und an vorgegebenen Trennstellen abtrennbar sind; und wobei die erste Widerstandsanordnung und die zweite Widerstandsanordnung an den jeweiligen Enden der Module Verbindungsanschlüsse aufweisen, die jeweils durchgehend von der Oberseite zur Unterseite vorgesehen sind, so dass sie sowohl von der Oberseite als auch von der Unterseite des Trägers kontaktiert werden können, und an denen sich eine weitere Widerstandsbaugruppe mit einem derartigen modularen Aufbau anschließen lässt.

Mit der erfindungsgemäßen Widerstandsbaugruppe wird die Aufgabe in zufriedenstellender Weise gelöst. Die Widerstandsanordnungen können in flächiger Weise unmittelbar auf dem Träger aufgebracht werden, sodass sich eine wesentlich homogenere Feldverteilung ergibt, wenn eine elektrische Spannung an eine derartige Widerstandsbaugruppe angelegt wird. Die beiden Widerstandsanordnungen können an dem einen Ende miteinander verbunden werden, sodass sich die Funktionstüchtigkeit auf elektrischen Durchgang am anderen Ende der Widerstandsbaugruppe prüfen lässt.

Eine derartige elektrische Funktionsprüfung kann Modul für Modul durchgeführt werden, oder auch für eine ausgewählte Reihe von miteinander verbundenen Modulen der Widerstandsbaugruppe und natürlich die gesamte Widerstandsbaugruppe durchgeführt werden. Bei Bedarf können auch ein oder mehrere Module durch Abtrennen entfernt werden, ohne dass die Funktionstüchtigkeit der übrig gebliebenen Widerstandsbaugruppe beeinträchtigt ist.

In Weiterbildung der erfindungsgemäßen Baugruppe ist vorgesehen, daß die Widerstandsanordnungen jeweils als flächig aufgebrachte Widerstandsbahnen, insbesondere in Mäanderform ausgebildet sind. Auf diese Weise lassen sich relativ hohe Widerstandswerte auf vergleichsweise kleiner Fläche realisieren. Es können jedoch auch andere Formen und geometrische Anordnungen der Widerstandsbahnen verwendet werden, solange die gewünschten Widerstandswerte erzielt werden. Zu diesem Zweck werden Materialien mit geeigneten spezifischen Widerstandswerten verwendet.

In Weiterbildung der erfindungsgemäßen Baugruppe ist vorgesehen, daß die erste Widerstandsanordnung und die zweite Widerstandsanordnung auf den beiden gegenüberliegenden Hauptflächen des Trägers achsensymmetrisch zueinander ausgebildet sind. Dann ist es in besonders einfacher Weise möglich, die beiden Widerstandsanordnungen elektrisch miteinander zu verbinden und hintereinander zu schalten. Andererseits sind die beiden Widerstandsanordnungen dann auch unabhängig voneinander einsetzbar.

Besonders zweckmäßig ist es, wenn bei der erfindungsgemäßen Baugruppe die Widerstandsanordnungen jeweils eine sich wiederholende Folge von miteinander verbundenen Widerstandsleitungen und Verbindungsleitungen aufweisen. Wird dann ein abtrennbarer Modul der Widerstandsbaugruppe entfernt, so erfolgt dies zweckmäßiger Weise im Bereich der Verbindungsleitungen, so daß sich die Widerstandswerte in diesen Bereichen nur geringfügig ändern und die Gesamtwiderstände der ersten Widerstandsanordnung bzw. der zweiten Widerstandsanordnung praktisch gleiche Werte beibehalten können.

In Weiterbildung der erfindungsgemäßen Baugruppe ist vorgesehen, daß die Module im gleichen Rasterabstand jeweils vier Verbindungsanschlüsse aufweisen, von denen zwei Verbindungsanschlüsse mit der ersten Widerstandsanordnung und zwei Verbindungsanschlüsse mit der zweiten Widerstandsanordnung verbunden sind. Auf diese Weise kann die Baugruppe in besonders vielseitiger Weise eingesetzt und verwendet werden.

In Weiterbildung der erfindungsgemäßen Baugruppe ist vorgesehen, daß die Module jeweils im wesentlichen den gleichen Aufbau haben und an den vorgegebenen Trennstellen abtrennbar sind. Auf diese Weise ergibt sich der Gesamtwiderstand der Baugruppe als ganzzahliges Vielfaches der Widerstandswerte der einzelnen Module.

In Weiterbildung der erfindungsgemäßen Baugruppe ist vorgesehen, daß die erste Widerstandsanordnung und die zweite Widerstandsanordnung an den beiden Enden des Trägers jeweils einen großflächigen Anschlußbereich für den Eingangsbereich bzw. den Ausgangsbereich der Baugruppe besitzen. Dann ist das Anschließen von entsprechenden Leitungen von einer Spannungsversorgung oder an ein Meßinstrument in besonders einfacher Weise möglich.

Die Anschlußbereiche für die erfindungsgemäße Baugruppe können unmittelbar auf dem Träger der Widerstandsbaugruppe ausgebildet sein. In Weiterbildung der Erfindung ist jedoch vorgesehen, daß die Anschlußbereiche für den Eingangsbereich bzw. den Ausgangsbereich auf separaten Anschlußmodulen ausgebildet sind, die an dem Eingangsbereich bzw. an dem Ausgangsbereich anbringbar sind.

Auf diese Weise ist es möglich, bei einer fertigen Widerstandsbaugruppe reine Widerstandsmodule einerseits und Anschlußmodule andererseits zu verwenden, so daß die Modulbauweise besonders gut ausgenutzt werden kann.

In Weiterbildung der Erfindung ist ein Verbindungsmodul vorgesehen, mit dem zwei Widerstandsbaugruppen der eingangs beschriebenen Art sich miteinander verbinden lassen. Auf diese Weise können mit derartigen Verbindungsmodulen zwei oder mehr Widerstandsbaugruppen mit derartigen Verbindungsmodulen verbunden und hintereinander geschaltet werden, um den Anforderungen der Praxis Rechnung zu tragen.

In Weiterbildung der Erfindung ist vorgesehen, daß die Anschlußmodule und die Verbindungsmodule mit ihren jeweiligen Leiterbahnen auf einem isolierenden langgestreckten Träger mit dem gleichen Rasteraufbau und mit Verbindungsanschlüssen im gleichen Rasterabstand wie bei den übrigen Modulen der Baugruppe ausgebildet sind. Auf diese Weise ergibt sich eine Vielzahl von Kombinationsmöglichkeiten, um einerseits die Widerstandsanordnungen miteinander zu verbinden und/oder die Widerstandsanordnungen an Spannungsversorgungen oder Meßstellen anzuschließen. Insbesondere ist bei der erfindungsgemäßen Baugruppe vorgesehen, daß der Verbindungsmodul auf den gegenüberliegenden Hauptflächen seines Trägers jeweils eine Leiterbahn aufweist, die sich jeweils zwischen zwei Verbindungsanschlüssen erstrecken, die den zwei Verbindungsanschlüssen der ersten Widerstandsanordnung bzw. den zwei Verbindungsanschlüssen der zweiten Widerstandsanordnung entsprechen. Diese Maßnahmen tragen dazu bei, in einfache Weise die mit den Widerstandsanordnungen versehenen Widerstandsbaugruppen miteinander zu kombinieren.

In Weiterbildung der erfindungsgemäßen Baugruppe ist vorgesehen, daß die Verbindungsanschlüsse als Lötstützpunkte mit integrierten elektrisch leitenden Buchsen ausgebildet sind, die die erste und die zweite Hauptfläche der jeweiligen Träger miteinander verbinden.

Daher ist es in einfacher Weise möglich, die Widerstandsbahnen und Leiterbahnen auf der einen Seite und der anderen Seite des Trägers zu Meßzwecken oder Anschlußzwecken miteinander zu verbinden. Es sind lediglich flächige Verbindungen oder kurze Verbindungsbügel erforderlich.

Besonders vorteilhaft ist es, wenn die Verbindungsanschlüsse bei der erfindungsgemäßen Baugruppe Löcher zur Aufnahme von Verbindungsteilen, insbesondere Stiften, aufweisen. Dann lassen sich die gewünschten Verbindungen in besonders einfacher Weise realisieren.

In Weiterbildung der Erfindung ist vorgesehen, daß sich bei der Widerstandsbaugruppe die Anschlußmodule und die Verbindungsmodule mittels anlötbarer Stifte mit den übrigen Trägern der übrigen Module verbinden lassen. Damit können die Verbindungen an den gewünschten Stellen in einfacher und zuverlässiger Weise realisiert werden.

Zweckmäßigerweise wird die erfindungsgemäße Widerstandsbaugruppe mit ihren jeweiligen Modulen in Form von gedruckten Leiterplatten in PCB-Technik realisiert. Dabei handelt es sich um eine ausgereifte Technik, die eine zuverlässige Realisierung der jeweiligen Widerstandsbaugruppen ermöglicht.

Die Erfindung wird nachstehend, auch hinsichtlich weiterer Merkmale und Vorteile, anhand der Beschreibung von Ausführungsbeispielen und unter Bezugnahme auf die beiliegenden Zeichnungen näher erläutert. Die Zeichnungen zeigen in
- Fig. 1: eine perspektivische schematische Draufsicht auf eine erfindungsgemäße Widerstandsbaugruppe aus mehreren Modulen;
- Fig. 2: eine schematische Draufsicht auf eine Widerstandsbaugruppe gemäß Fig. 1, bei der ein Modul abgetrennt ist;
- Fig. 3: eine schematische perspektivische Darstellung zur Erläuterung der Verbindung von zwei Widerstandsbaugruppen mit einem Verbindungs- modul;
- Fig. 4: einen schematischen Schnitt durch eine Verbindung von Widerstandsbau- gruppen gemäß Fig. 3;
- Fig. 5: eine schematische perspektivische Draufsicht auf eine kombinierte Widerstandsbaugruppe;
- Fig. 6a: eine Draufsicht auf eine derartige Verbindung von Widerstandsbau- gruppen von oben;
- Fig. 6b: eine Draufsicht auf eine Verbindung von Widerstandsbaugruppen von unten;
- Fig. 7: eine schematische Darstellung zur Erläuterung des Einbaus einer erfin- dungsgemäßen Widerstandsbaugruppe in einem Rohr zu Meßzwecken;
- Fig. 8 bis 17: schematische Darstellungen zur Erläuterung der verschiedenen Module und deren Kombination miteinander bei einer erfindungsgemäßen Wider- standsbaugruppe; im einzelnen zeigen:

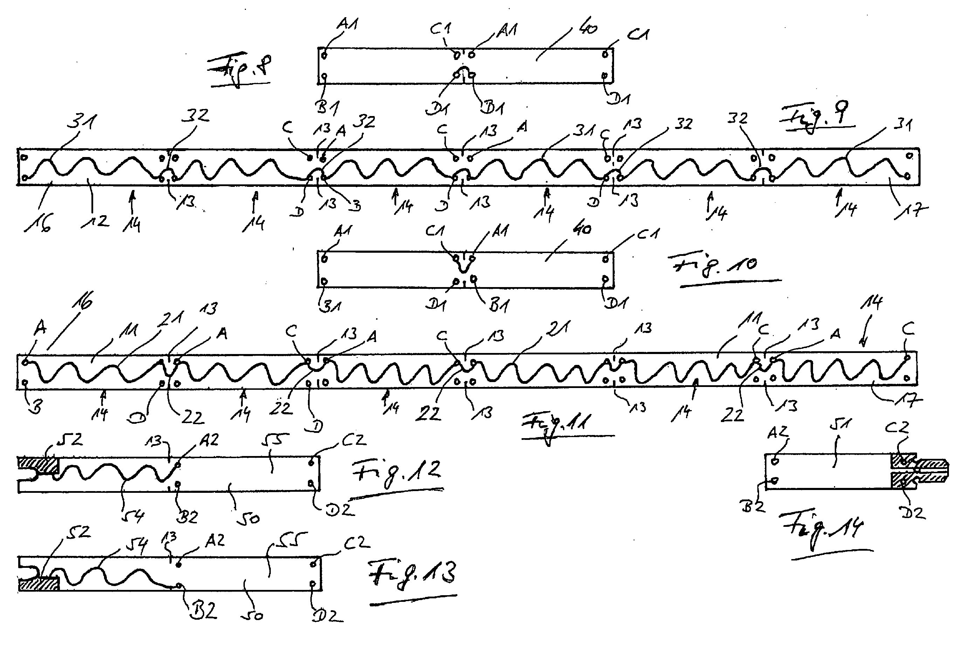

- Fig. 8: eine schematische Durchsicht von oben durch einen Verbindungsmodul;
- Fig. 9: eine schematische Durchsicht von oben durch eine Widerstandsbaugruppe mit mehreren Modulen;
- Fig. 10: eine schematische Draufsicht eines Verbindungsmoduls;
- Fig. 11: eine schematische Draufsicht einer Verbindungsbaugruppe mit mehreren Verbindungsmodulen;
- Fig. 12: eine schematische Draufsicht eines Anschlußmoduls;
- Fig, 13: eine schematische Durchsicht von oben durch einen Anschlußmodul;
- Fig. 14: eine schematische Draufsicht auf einen Anschlußmodul für einen End- bereich;

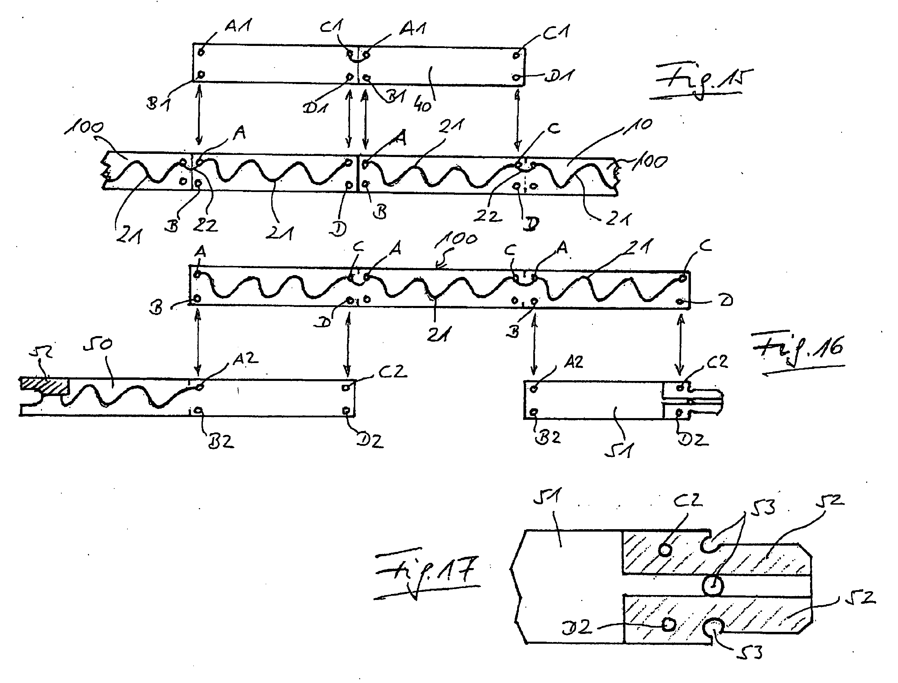

- Fig. 15: eine schematische Zuordnung von zwei separaten Widerstandsbau- gruppen, die mit einem Verbindungsmodul zu verbinden sind;
- Fig. 16: eine schematische Zuordnung von einer Widerstandsbaugruppe sowie Anschlußmodulen, die im Eingangsbereich bzw. im Endbereich anzu- schließen sind;
- Fig. 17: eine vergrößerte Darstellung eines Anschlußmoduls für einen End- bereich;
- Fig. 18: einen schematischen Querschnitt durch ein Trägerrohr, in dem ein Träger einer erfindungsgemäßen Widerstandsbaugruppe angeordnet ist;
- Fig. 19: eine der Fig. 18 ähnliche Darstellung, bei der ein Träger mit einer erfin- dungsgemäßen Widerstandsbaugruppe mittels Abstandshaltern in dem Trägerrohr angebracht ist;
- Fig. 20: einen schematischen Querschnitt durch ein Trägerrohr mit einer erfin- dungsgemäßen Widerstandsbaugruppe zur Erläuterung der elektrischen Feldverteilung; und in
- Fig. 21: einen schematischen Schnitt durch ein Trägerrohr, in welchem eine her- kömmliche Widerstandsbaugruppe mit einzelnen Widerstandselementen angebracht ist, einschließlich der dortigen inhomogenen elektrischen Feldverteilung.

In diesem Zusammenhang ist der Begriff "Durchsicht" so zu verstehen, daß die Anordnung von oben, durch den Träger hindurch betrachtet und dabei nur die Belegung auf der unteren Ebene berücksichtigt wird, um die geometrische Zuordnung in Relation zu der oberen Ebene gemäß der Draufsicht zu erläutern.

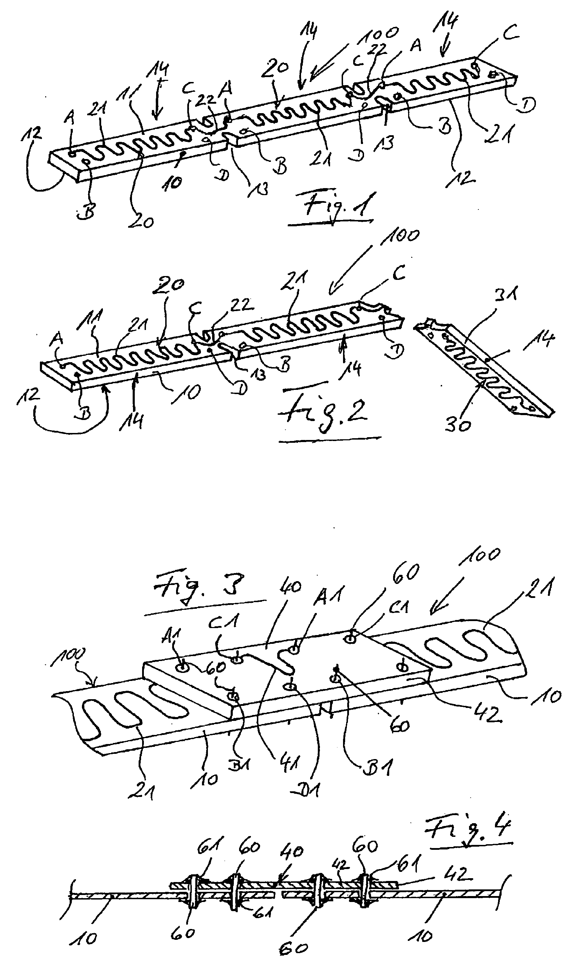

Fig. 1 zeigt eine schematische Darstellung einer erfindungsgemäßen Widerstandsbaugruppe, die insgesamt mit 100 bezeichnet ist. Man erkennt einen durchgehenden Träger 10, der als Leiterplatte ausgebildet ist und an seiner Oberseite 11 eine erste Widerstandsanordnung 20 aufweist. Die erste Widerstandsanordnung 20 erstreckt sich von dem einen Ende des Trägers durchgehend zum anderen Ende und weist in abwechselnder Folge eine Widerstandsleitung 21 und eine Verbindungsleitung 22 auf, die durchgehend miteinander verbunden sind. Auf der Unterseite 12 des Trägers 10 ist dann eine zweite Widerstandsanordnung 30 vorgesehen, die wiederum aus einer abwechselnden Folge aus Widerstandsleitungen 31 und Verbindungsleitungen 32 besteht.

Wie aus Fig. 1 und Fig. 2 ersichtlich, ist die gesamte Widerstandsbaugruppe 100 aus mehreren Modulen 14 aufgebaut, die integral miteinander ausgebildet sind und Nuten oder Kerben als Trennstellen 13 aufweisen, an denen einzelne Module der Widerstandsbaugruppe 100 bei Bedarf abgetrennt werden können.

Jeder Modul 14 hat eine vorgegebene Länge und Breite, wobei in vorgegebenen Rasterabständen in Längsrichtung des Trägers 10 Verbindungsanschlüsse A, B, C und D vorgesehen sind. Diese Verbindungsanschlüsse haben in Längsrichtung einen konstanten Rasterabstand zwischen den Verbindungsanschlüssen A und C sowie C und A usw., wobei der gleiche konstante Rasterabstand zwischen den Verbindungsanschlüssen B und D sowie D und B usw. vorgegeben ist. In Querrichtung ist ein konstanter Rasterabstand zwischen den Verbindungsanschlüssen A und B sowie zwischen C und D vorgegeben.

Dementsprechend verläuft die erste Widerstandsanordnung 20 durchgehend von dem Verbindungsanschluß A an einem Ende über die Widerstandsleitungen 21 und Verbindungsleitungen 22 durchgehend zum Verbindungsanschluß C an dem anderen Ende des Trägers 10. Entsprechend verläuft die zweite Widerstandsanordnung 30 an der Unterseite des Trägers von dem Verbindungsanschluß B über die Widerstandsleitungen 31 und Verbindungsleitungen 32 zum Verbindungsanschluß D am anderen Ende des Trägers 10. Die Widerstandsanordnungen 20 und 30 haben dabei Modul für Modul über die Länge des Trägers 10 im wesentlichen die gleichen Widerstandswerte.

Diese beiden Widerstandsanordnungen 20 und 30 sind zunächst unabhängig voneinander vorgesehen. Man erkennt in Fig. 1 und Fig. 2 jedoch, daß die Verbindungsanschlüsse A, B, C und D jeweils durchgehend von der Oberseite 11 zur Unterseite 12 vorgesehen sind, mit der Folge, daß diese Verbindungsanschlüsse A bis D sowohl von der Oberseite 11 als auch von der Unterseite 12 des Trägers 10 kontaktiert werden können.

Insbesondere ist es möglich, an gewünschten Stellen die Verbindungsanschlüsse C und D oder die Verbindungsanschlüsse A und B miteinander zu verbinden und dadurch Reihenschaltungen von Widerständen zu realisieren oder zu messende Objekte zwischen zwei derartige Verbindungsanschlüsse zu schalten.

Dabei ist es besonders vorteilhaft, daß man mit einer derartigen Bauweise Modul für Modul oder auch über die gesamte Länge des Trägers 10 mit sämtlichen Modulen Meßbrücken anbringen und auf diese Weise den elektrischen Durchgang der jeweiligen Module oder der Gesamtanordnung der Widerstandsbaugruppe 100 prüfen kann.

In Fig. 3 ist in vereinfachter schematischer Weise dargestellt, wie ein Verbindungsmodul 40 zwei Widerstandsbaugruppen 100 miteinander verbindet, um auf diese Weise etwa eine besondere hochohmige Widerstandsbaugruppe zu realisieren. Man erkennt in Fig. 3 einen Verbindungsmodul 40 mit einer Verbindungsleitung 41, die in diesem Falle die Verbindungsanschlüsse C1 und A1 auf der einen Seite ihrer Leiterplatte 42 miteinander verbindet.

Auf der gegenüberliegenden Seite, die in Fig. 3 nicht zu sehen ist, erstreckt sich dann eine entsprechende Verbindungsleitung zwischen den Verbindungsanschlüssen D1 und B1. Die Verbindung des Verbindungsmoduls 40 mit den Widerstandsbaugruppen 100 wird dabei mit Stiften 60 realisiert, die mit entsprechenden Verbindungsanschlüssen A bis D in den jeweiligen Modulen der Widerstandsbaugruppen 100 verbunden, insbesondere angelötet sind.

In Fig. 4 erkennt man im Schnitt derartige Verbindungsstifte 60, die durch die Leiterplatten bzw. Träger 10 und 42 hindurchgehen und an den gegenüberliegenden Seiten mittels Lötstellen 61 fixiert sind. Diese Lötstellen 61 sorgen dabei in üblicher Weise sowohl für eine elektrische als auch eine mechanisch zuverlässige Verbindung.

Wenn in der in Fig. 3 dargestellten Weise der Verbindungsmodul 40 zwei aneinander stoßende Enden von Widerstandsbaugruppen 100 überlappt und insgesamt acht Stifte 60 zur Verbindung der Komponenten vorgesehen sind, ergibt sich eine zuverlässige stabile Konstruktion.

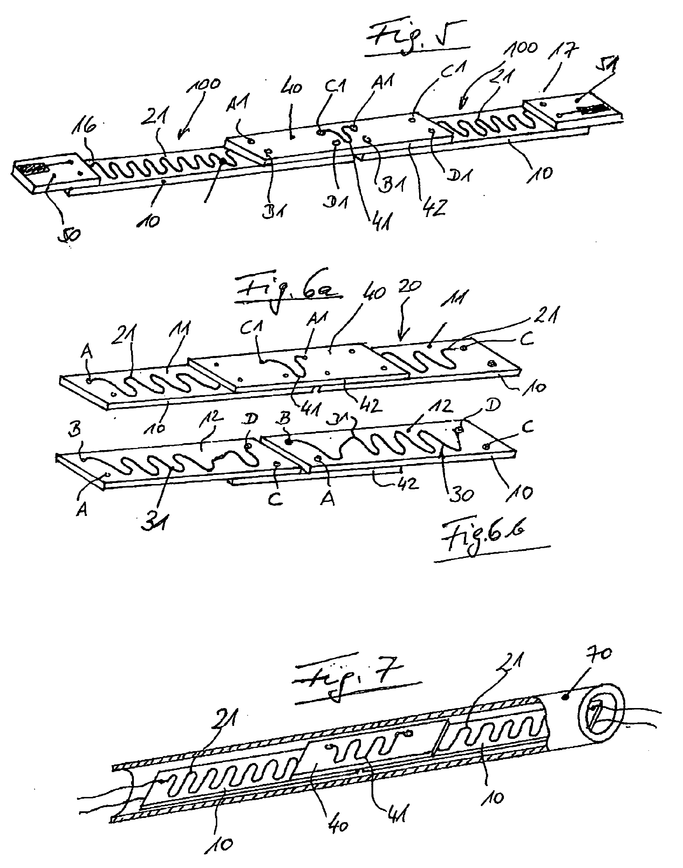

Fig. 5, Fig. 6a und Fig. 6b dienen der weiteren Erläuterung einer derartigen Verbindung der Widerstandsbaugruppe 100 mit einem solchen Verbindungsmodul 40. Außerdem ist im Eingangsbereich 16 einer Widerstandsbaugruppe 100 ein Anschlußmodul 50 vorgesehen, während im Ausgangsbereich einer weiteren Widerstandsbaugruppe 100 ein anderer Anschlußmodul 51 vorgesehen ist.

Bei der Darstellung gemäß Fig. 6a ist die eine Seite des Verbindungsmoduls 40 erkennbar, deren Verbindungsleitung 41 zwischen den Verbindungsanschlüssen A1 und C1 verläuft und beispielsweise mit nicht dargestellten Stiften gemäß Fig. 3 mit entsprechenden Verbindungsanschlüssen A und C des Trägers 10 verbunden ist.

Fig. 6b zeigt die gegenüberliegende Seite im Verbindungsbereich zwischen zwei derartigen Trägern 10 mit dem Verbindungsmodul 40, wobei die auf der anderen Seite des Verbindungsmoduls 40 vorgesehene Verbindungsleitung 41 dann die Verbindungsanschlüsse D1 und B1 miteinander verbindet und dann zu den Verbindungsanschlüssen D und B der jeweiligen Träger 10 durchkontaktiert sind.

Für diese Konstruktion der Widerstandsbaugruppen 100 ist es zweckmäßig, wenn die erste Widerstandsanordnung 20 sowie die zweite Widerstandsanordnung 30 auf der Oberseite 11 bzw. der Unterseite 12 des Trägers 10 achsensymmetrisch zueinander ausgeführt sind, so daß diese jeweils an den gegenüberliegenden Punkten A und B bzw. C und D der jeweiligen Module 14 enden.

Die Verbindungsanschlüsse selbst sind zweckmäßigerweise als Lötstützpunkte mit integrierten elektrisch leitenden Buchsen ausgebildet, die sich quer durch den jeweiligen Träger 10 der Widerstandsbaugruppe 100 erstrecken und damit die ersten Hauptfläche 11 und die zweite Hauptfläche 12 des Trägers 10 miteinander verbinden. Derartige Verbindungsanschlüsse besitzen Durchgangslöcher, die sich zur Aufnahme von Verbindungsteilen, insbesondere Stiften eignen, beispielsweise den in Fig. 3 und Fig. 4 schematisch angedeuteten Stiften 60. Selbstverständlich können auch andere Verbindungsteile, wie etwa Bügel zu diesem Zweck verwendet werden, wenn dies zweckmäßig erscheint.

Die in Fig. 5 angedeuteten Anschlußmodule 50 und 51 sind in näheren Einzelheiten in Fig. 12 bis Fig. 14 dargestellt. Sie weisen jeweils Leiterbahnen 54 auf einer Leiterplatte 55 auf, die von Verbindungsanschlüssen zu verbreiterten Anschlußflächen 52 führen, die für Lötverbindungen zum Kontaktieren von Anschlußleitungen ausgebildet sind. Für den Ausgangsbereich 17 einer Widerstandsbaugruppe 100 kann es zweckmäßig sein, wenn die Anschlußflächen zu beiden Seiten der Längsachse des Anschlußmoduls 51 ausgebildet sind, wie es in Fig. 14 dargestellt ist.

Die in Fig. 17 angedeuteten Bohrungen 53 im Anschlußmodul 51 dienen als Trennhilfe, um den in Fig. 16 auf der rechten Seite erkennbaren vorspringenden Bereich abzutrennen, wenn dies zweckmäßig sein sollte.

Wie in den Figuren 12 bis 14 dargestellt, besitzen die Anschlußmodule 50 und 51 Verbindungsanschlüsse A2 bis D2, die selbstverständlich in den gleichen Rasterabständen angeordnet sind wie die Verbindungsanschlüsse A bis D im Träger 10 der Widerstandsbaugruppe 100. Dabei ist das gleiche Rastermaß, wie bereits erwähnt, auch beim Verbindungsmodul 40 vorgesehen. Es versteht sich von selbst, daß der Rasterabstand in Querrichtung, also zwischen A und B, A1 und B1, A2 und B2 sowie C und D, C1 und D1 und C2 und D2 ebenfalls konstant vorgegeben ist.

In Fig. 15 und Fig. 16 ist im einzelnen die Zuordnung von derartigen Anschlußmodulen 50 und 51 sowie eines Verbindungsmoduls 40 dargestellt, wobei in Fig. 15 zwei Widerstandsbaugruppen 100 zu verbinden sind, während in Fig. 16 zwei Anschlußmodule 50 und 51 mit einer Widerstandsbaugruppe 100 zu verbinden sind.

Anhand der Doppelpfeile ist ersichtlich, wie die Zuordnung der Verbindungsanschlüsse A bis D sowie A1 bis D1 einerseits oder der Verbindungsanschlüsse A bis D und der Verbindungsanschlüsse A2 bis D2 andererseits vorzunehmen ist, um die entsprechenden Kombinationen zu realisieren.

Die Verbindungsmodule 40 sind in der dargestellten Weise so vorgesehen, daß sie jeweils zwei Moduleinheiten aufweisen, die dann mit jeweils einem Modul 14 einer Widerstandsbaugruppe 100 überlappen. Auf diese Weise wird die mechanische Verbindung von zwei derartigen Widerstandsbaugruppen 100 über die Länge der beiden Moduleinheiten verteilt, um eine besonders stabile Bauform der gesamten Konstruktion zu erzielen, da sich die mechanischen Belastungen über eine geeignete Länge verteilen. Wenn es gewünscht ist, können derartige Verbindungsmodule 40 selbstverständlich auch kürzer ausgebildet sein und lediglich vier Verbindungsanschlüsse A1 bis D1 aufweisen, die den Anschlußbereich von zwei Widerstandsbaugruppen 100 überlappen, wenn beispielsweise Material eingespart werden soll.

Die großflächig ausgebildeten Anschlußflächen 52 können selbstverständlich auch unmittelbar an den jeweiligen Enden des Trägers in Längsrichtung des Trägers 10 vorgesehen sein, etwa innerhalb eines Moduls am Anfang bzw. am Ende des Trägers 10, oder aber als integrale achsene Verlängerungen des Trägers 10 , wenn dies zweckmäßig erscheint.

Allerdings ist der konsequente modulare Aufbau der Widerstandsbaugruppen 100 der Verbindungsmodule 40 sowie der Anschlußmodule 50 und 51 zweckmäßig, weil auf diese Weise eine größere Vielseitigkeit für die Praxis realisiert wird. Die Widerstandsbaugruppen lassen sich dann in exakter Weise hinsichtlich ihrer Widerstandswerte produzieren. In Abhängigkeit von den jeweiligen Gegebenheiten werden dann derartige Widerstandsbaugruppen 100 miteinander kombiniert und zu größeren Gesamtwiderständen zusammengesetzt. Die Anschlüsse selbst werden dann mit entsprechenden Anschlußmodulen 50 und 51 realisiert, die ihrerseits nur Leiterbahnen besitzen, die den Gesamtwiderstandswert einer Widerstandsbaugruppe nicht nennenswert beeinflussen.

Auch die Bevorratung wird vereinfacht, da dann nur vier Modultypen erforderlich sind, nämlich die eigentlichen Widerstandsmodule, Verbindungsmodule sowie Anschlußmodule für die jeweiligen Enden.

Wenn dabei die Widerstandsanordnungen als flächig aufgebrachte Widerstandsbahnen in Mäanderform ausgebildet sind, ist eine besonders kompakte und sehr effiziente Bauform möglich. Wenn dabei einige nebeneinander liegende Windungen der Mäanderform zusätzlich an den Köpfen miteinander verbunden sind, so können diese Kurzschlußverbindungen zu Trimmzwecken geöffnet werden, um Feinabstimmungen der Widerstandswerte innerhalb der Widerstandsbaugruppe vorzunehmen. Selbstverständlich können auch andere Formen und Geometrien der Widerstandsbahnen verwendet werden, wenn damit die gewünschten Widerstandswerte erzielt werden, und zwar durch die Wahl der Materialien mit geeigneten spezifischen Widerständen.

Die genannten Komponente, also die Widerstandsbaugruppen, Verbindungsmodule und Anschlußmodule lassen sich zweckmäßigerweise als gedruckte Leiterplatten in

PCB-Technik ausbilden, wobei geeignete Materialien für die Widerstandsleitungen bzw. die Verbindungsleitungen verwendet werden.

Fig. 18 zeigt schematisch einen Anwendungsfall einer Widerstandsbaugruppe 100 für eine Meßeinrichtung, wobei die Widerstandsbaugruppe 100 zentral in einem entsprechenden Trägerrohr 70 angeordnet ist. Bei geeigneter Dimensionierung sitzt die Widerstandsbaugruppe dann automatisch richtig in der Mitte eines derartigen schützenden Trägerrohres 70. Anderenfalls ist es auch möglich, gemäß Fig. 19 Abstandshalter 71 zu verwenden, die dann eine Widerstandsbaugruppe 100 in der Mittelebene eines Trägerrohres 70 halten.

Fig. 20 zeigt schematisch eine derartige Widerstandsbaugruppe 100 in der Mittelebene eines Trägerrohres 70, wobei die erste Widerstandsanordnung 20 und die zweite Widerstandsanordnung 30 in flächiger Ausbildung auf der Oberseite 11 bzw. der Unterseite 12 des Trägers 10 vorgesehen sind. Bei einer derartigen Bauform ergibt sich eine relativ homogene Feldverteilung des elektrischen Feldes 80, das sich um eine derartige Widerstandsbaugruppe 100 ausbildet, wenn eine entsprechende Spannung an die Widerstandsbaugruppe 100 angelegt ist.

## Patentansprüche

1. Widerstandsbaugruppe, die folgendes aufweist:
- einen isolierenden, langgestreckten Träger (10) mit zwei einander gegenüberliegenden Hauptflächen (11, 12), die eine Oberseite (11) und eine Unterseite (12) des Trägers (10) bilden,
- eine auf der einen Hauptfläche (11) des Trägers (10) vorgesehene erste Widerstandsanordnung (20), die sich über die Länge des Trägers (10) erstreckt,
- eine auf der anderen, gegenüberliegenden Hauptfläche (12) des Trägers (10) vorgesehene zweite Widerstandsanordnung (30), die sich über die Länge des Trägers (10) erstreckt,
- wobei die Widerstandsbaugruppe (100) aus einer Vielzahl von Modulen (14) aufgebaut ist, die
a) integral miteinander ausgebildet sind,
b) jeweils miteinander verbundene Teile der ersten Widerstandsanordnung (20) und miteinander verbundene Teile der zweiten Widerstandsanordnung (30) tragen und
c) an vorgegebenen Trennstellen abtrennbar sind, und
- wobei die erste Widerstandsanordnung (20) und die zweite Widerstandsanordnung (30) an den jeweiligen Enden der Module (14) Verbindungsanschlüsse (A - D) aufweisen, die jeweils durchgehend von der Oberseite (11) zur Unterseite (12) vorgesehen sind, so dass sie sowohl von der Oberseite (11) als auch der Unterseite (12) des Trägers (10) kontaktiert werden können, und an denen sich eine weitere Widerstandsbaugruppe (100) mit einem derartigen modularen Aufbau anschließen lässt.

2. Baugruppe nach Anspruch 1,
**dadurch gekennzeichnet,**
**daß** die Widerstandsanordnungen (20, 30) jeweils als aufgebrachte Widerstandsbahnen, insbesondere in Mäanderform ausgebildet sind.

3. Baugruppe nach Anspruch 1 oder 2,
**dadurch gekennzeichnet,**
**daß** die erste Widerstandsanordnung (20) und die zweite Widerstandsanordnung (30) auf den beiden gegenüberliegenden Hauptflächen (11, 12) des Trägers (10) achsensymmetrisch zueinander ausgebildet sind.

4. Baugruppe nach einem der Ansprüche 1 bis 3,
**dadurch gekennzeichnet,**
**daß** die Widerstandsanordnungen (20, 30) jeweils eine sich wiederholende Folge von miteinander verbundenen Widerstandsleitungen (21, 31) und Verbindungsleitungen (22, 32) aufweisen.

5. Baugruppe nach einem der Ansprüche 1 bis 4,
**dadurch gekennzeichnet,**
**daß** die Module (14) im gleichbleibenden konstanten Rasterabstand jeweils vier Verbindungsanschlüsse (A - D) aufweisen, von denen zwei Verbindungsanschlüsse (A, C) mit der ersten Widerstandsanordnung (20) und zwei Verbindungsanschlüsse (B, D) mit der zweiten Widerstandsanordnung (30) verbunden sind.

6. Baugruppe nach einem der Ansprüche 1 bis 5,
**dadurch gekennzeichnet,**
**daß** die Module (14) jeweils im wesentlichen den gleichen Aufbau haben und an vorgegebenen Trennstellen (13) abtrennbar sind.

7. Baugruppe nach einem der Ansprüche 1 bis 6,
**dadurch gekennzeichnet,**
**daß** die erste Widerstandsanordnung (20) und die zweite Widerstandsanordnung (30) an den beiden Enden des Trägers (10) jeweils einen großflächigen Anschlußbereich (52) für den Eingangsbereich (16) bzw. den Ausgangsbereich (17) aufweisen.

8. Baugruppe nach Anspruch 7,
**dadurch gekennzeichnet,**
**daß** die Anschlußbereiche (A2 - D2) mit dem Eingangsbereich (16) bzw. dem Ausgangsbereich (17) auf separaten Anschlußmodulen (50, 51) ausgebildet sind, die an dem Eingangsbereich (16) bzw. an dem Ausgangsbereich (17) anbringbar sind.

9. Baugruppe nach einem der Ansprüche 1 bis 8,
**gekennzeichnet durch** einen Verbindungsmodul (40), mit dem zwei Widerstandsbaugruppen nach einem der Ansprüche 1 bis 8 miteinander verbunden sind.

10. Baugruppe nach Anspruch 8 oder 9,
**dadurch gekennzeichnet,**
**daß** die Anschlußmodule (50, 51) und die Verbindungsmodule (40) mit ihren jeweiligen Leiterbahnen (41, 54) auf einem isolierenden langgestreckten Träger (42, 55) mit dem gleichen Rasteraufbau und mit Verbindungsanschlüssen (A1 - D1; A2 - D2) im gleichen Rasterabstand wie bei den übrigen Modulen (14) der Baugruppe ausgebildet sind.

11. Baugruppe nach Anspruch 9 oder 10,
**dadurch gekennzeichnet,**
**daß** der Verbindungsmodul (40) auf den gegenüberliegenden Hauptflächen seines Trägers (42) jeweils eine Leiterbahn (41) aufweist, die sich jeweils zwischen zwei Verbindungsanschlüssen (A1 - C1; B1 - D1) erstrecken, die den zwei Verbindungsanschlüssen (A - C, B - D) der ersten Widerstandsanordnung (20) bzw. den zwei Verbindungsanschlüssen (A - C, B - D) der zweiten Widerstandsanordnung (30) entsprechen.

12. Baugruppe nach einem der Ansprüche 1 bis 11,
**dadurch gekennzeichnet,**
**daß** die Verbindungsanschlüsse (A - D; A1 - D1; A2 - D2) als Lötstützpunkte mit integrierten elektrisch leitenden Buchsen ausgebildet sind, die die erste und die zweite Hauptfläche (11, 12) der jeweiligen Träger (10, 42, 55) miteinander verbinden.

13. Baugruppe nach einem der Ansprüche 1 bis 12,
**dadurch gekennzeichnet,**
**daß** die Verbindungsanschlüsse (A - D; A1 - D1; A2 - D2) Löcher zur Aufnahme von Verbindungsteilen, insbesondere von Stiften aufweisen.

14. Baugruppe nach einem der Ansprüche 8 bis 13,
**dadurch gekennzeichnet,**
**daß** die Anschlußmodule (50, 51) und die Verbindungsmodule (40) sich mittels anlötbaren Stiften (60) mit den Trägern der übrigen Module (14) verbinden lassen.

15. Baugruppe nach einem der Ansprüche 1 bis 14,
**dadurch gekennzeichnet,**
**daß** die Widerstandsbaugruppe mit ihren jeweiligen Modulen (14, 40, 50, 51) als gedruckte Leiterplatten in PCB-Technik ausgebildet sind.

## Claims

1. A resistor assembly, comprising:
- an insulating elongated carrier (10) having two opposite main surfaces (11, 12) forming a top side (11) and a bottom side (12) of the carrier (10),
- a first resistor array (20) provided on the one main surface (11) of the carrier (10) and extending over the length of the carrier (10),
- a second resistor array (30) provided on the other opposite main surface (12) of the carrier (10) and extending over the length of the carrier (10)
- wherein the resistor assembly (100) is formed by a plurality of modules (14), which
a) are integrally formed with each other,
b) carry parts of the first resistor array (20) respectively connected with each other, and parts of the second resistor array (30) respectively connected with each other, and
c) are detachable at predetermined separation locations, and
- wherein the first resistor array (20) and the second resistor array (30) comprise connection terminals (A - D) at the respective ends of the modules (14) wherein the connection terminals are provided continuously from the top side (11) to the bottom side (12) in such a manner that they can be contacted both from the top side (11) and the bottom side (12) of the carrier (10), and to which a further resistor assembly (100) with such a modular structure can be connected.

2. The assembly according to claim 1,
**characterized in that** the resistor arrays (20, 30) are respectively formed as resistor lines applied thereon, in particular having a meander shape.

3. The assembly according to any one of claims 1 or 2,
**characterized in that** the first resistor array (20) and the second resistor array (30) are formed on the two opposite main surfaces (11, 12) of the carrier (10) in an axial-symmetric manner.

4. The assembly according to any of claims 1 or 3,
**characterized in that** each of the resistor arrays (20, 30) comprises a repeating sequence of resistor lines (21, 31) and connecting lines (22, 32) connected with each other.

5. The assembly according to any of claims 1 to 4,
**characterized in that** the modules (14) each comprise four connection terminals (A - D) provided at a constant equal spacing, wherein two connection terminals (A, C) are connected with the first resistor array (20) and two connection terminals (B, D) are connected with the second resistor array (30).

6. The assembly according to any of claims 1 to 5,
**characterized in that** the modules (14) respectively have essentially the same structure and are detachable at predetermined separation locations (13).

7. The assembly according to any of claims 1 to 6,
**characterized in that** the first resistor array (20) and the second resistor array (30) each comprise a large area terminal portion (52) for the input area (16) and the output area (17) at the two ends of the carrier (10).

8. The assembly according to claim 7,
**characterized in that** the terminal portions (A2 - D2), having the input area (16) and the output area (17), respectively, are formed on separate terminal modules (50, 51) which can be mounted to the input area (16) and the output area (17), respectively.

9. The assembly according to any one of claims 1 to 8,
**characterized by** a connection module (40) by means of which two resistor assemblies according to any one of claims 1 to 8 are connected with each other.

10. The assembly according to any one of claims 8 or 9,
**characterized in that** the terminal modules (50, 51) and the connection modules (40) are formed with their respective conductor lines (41, 54) on an insulating elongated carrier (42, 55) having the same constant equal spacing structure and having connection terminals (A1 - D1; A2 - D2) having the same constant equal spacing as with the other modules (14) of the assembly.

11. The assembly according to any one of claims 9 or 10,
**characterized in that** the connection module (40) comprises a respective conductor line (41) on the opposite main surfaces of its carrier (42), wherein the conductor lines respectively extend between two connection terminals (A1 - C1; B1 - D1) which correspond to the two connection terminals (A - C, B - D) of the first resistor array (20), and the two connection terminals (A - C, B - D) of the second resistor array (30).

12. The assembly according to any of claims 1 to 11,
**characterized in that** the connection terminals (A - D; A1 - D1; A2 - D2) are formed as solder bases having integrated electrically conducting bushings which connect the first and the second main surfaces (11, 12) of the respective carriers (10, 42, 55) with each other.

13. The assembly according to any one of claims 1 to 12,
**characterized in that** the connection terminals (A - D; A1 - D1, A2 - D2) comprise holes for receiving connection parts, in particular pins.

14. The assembly according to any one of claims 8 to 13,
**characterized in that** the terminal modules (50, 51) and the connection modules (40) can respectively be connected with each other by means of solderable pins (60) to the carriers of the other modules (14).

15. The assembly according to any one of claims 1 to 14,
**characterized in that** the resistor assembly with its corresponding modules (14, 40, 50, 51) are formed as printed circuit boards in PCB technology.

## Revendications

1. Groupe structurel à résistances, qui comprend les éléments suivants :
- un support allongé isolant (10) présentant deux surfaces principales mutuellement opposées (11, 12), qui forment une face supérieure (11) et une face inférieure (12) du support (10),
- un premier agencement de résistances (20), prévu sur l'une des surfaces principales (11) du support (10), qui s'étend sur la longueur du support (10),
- un second agencement de résistances (30), prévu sur l'autre surface principale opposée (12) du support (10), qui s'étend sur la longueur du support (10),
dans lequel le groupe structurel à résistances (100) est composé d'une pluralité de modules (14),
a) qui sont réalisés de manière intégrale les uns avec les autres,
b) qui portent respectivement des parties mutuellement reliées du premier agencement de résistances (20) et des parties mutuellement reliées du second agencement de résistances (30), et
c) sont séparables au niveau d'emplacements de séparation prédéterminés, et
dans lequel le premier agencement de résistances (20) et le second agencement de résistances (30) comportent, aux extrémités respectives des modules (14), des bornes de connexion (A-D) qui sont prévues respectivement en continu depuis la face supérieure (11) vers la face inférieure (12), de sorte qu'elles peuvent recevoir un contact aussi bien depuis la face supérieure (11) que depuis la face inférieure (12) du support (10), et auxquelles peut être connecté un autre groupe structurel à résistances (100) présentant une construction modulaire de ce type.

2. Groupe structurel selon la revendication 1,
**caractérisé en ce que** les agencements de résistances (20, 30) sont réalisés respectivement comme des pistes résistives rapportées, en particulier en forme de méandres.

3. Groupe structurel selon la revendication 1 ou 2,
**caractérisé en ce que** le premier agencement de résistances (20) et le second agencement de résistances (30) sont réalisés sur les deux surfaces principales opposées (11, 12) du support (10) avec une symétrie axiale l'un par rapport à l'autre.

4. Groupe structurel selon l'une des revendications 1 à 3,
**caractérisé en ce que** les agencements de résistances (20, 30) présentent respectivement une succession répétitive de lignes résistives (21, 31) et de lignes de liaison (22, 32) reliées les unes aux autres.

5. Groupe structurel selon l'une des revendications 1 à 4,
**caractérisé en ce que** les modules présentent, à une distance de trame qui reste constante, respectivement quatre bornes de connexion (A-D), parmi lesquelles deux bornes de connexion (A, C) sont reliées au premier agencement de résistances (20) et deux bornes de connexion (B, D) sont reliées au second agencement de résistances (30).

6. Groupe structurel selon l'une des revendications 1 à 5,
**caractérisé en ce que** les modules (14) ont respectivement sensiblement la même structure et sont séparables à des emplacements de séparation prédéterminés (13).

7. Groupe structurel selon l'une des revendications 1 à 6,
**caractérisé en ce que** le premier agencement de résistances (20) et le second agencement de résistances (30) présentent aux deux extrémités du support (10) chacun une zone de connexion (52) de grande surface pour la zone d'entrée (16) ou respectivement pour la zone de sortie (17).

8. Groupe structurel selon la revendication 7,
**caractérisé en ce que** les zones de connexion (A2-D2) avec la zone d'entrée (16) ou respectivement avec la zone de sortie (17) sont réalisées sur des modules de connexion séparés (50, 51), qui peuvent être rapportés sur la zone d'entrée (16) ou respectivement sur la zone de sortie (17).

9. Groupe structurel selon l'une des revendications 1 à 8,
**caractérisé par** un module de liaison (40) avec lequel deux groupes structurels à résistances selon l'une des revendications 1 à 8 sont reliés l'un à l'autre.

10. Groupe structurel selon la revendication 8 ou 9,
**caractérisé en ce que** les modules de connexion (50, 51) et les modules de liaison (40) sont reliés sur un support allongé isolant (42, 55) avec la même disposition en trame et avec des bornes de connexion (A1-D1 ; A2-D2) présentant la même distance de trame que dans les autres modules (14) du groupe structurel.

11. Groupe structurel selon la revendication 9 ou 10,
**caractérisé en ce que** le module de liaison (40) comporte sur les surfaces principales opposées de son support (42) une piste conductrice respective (41), lesquelles s'étendent entre deux bornes de connexion respectives (A1-C1 ; B1-D1), qui correspondent aux deux bornes de connexion (A-C, B-D) du premier agencement de résistances (20) ou aux deux bornes de connexion (A-C, B-D) du second agencement de résistances (30).

12. Groupe structurel selon l'une des revendications 1 à 11,
**caractérisé en ce que** les bornes de connexion (A-D ; A1-D1 ; A2-D2) sont réalisées sous forme de point de support de brasage avec des douilles électriquement conductrices intégrées, qui relient l'une à l'autre la première et la seconde surface principale (11, 12) du support respectif (10, 42, 55).

13. Groupe structurel selon l'une des revendications 1 à 12,
**caractérisé en ce que** les bornes de connexion (A-D ; A1-D1 ; A2-D2) comportent des trous pour recevoir des pièces de connexion, en particulier des broches.

14. Groupe structurel selon l'une des revendications 8 à 13,
**caractérisé en ce que** les modules de connexion (50, 51) et les modules de liaison (40) peuvent être reliés avec les supports des autres modules (14) au moyen de tiges (60) à braser.

15. Groupe structurel selon l'une des revendications 1 à 14,
**caractérisé en ce que** les groupes structurels à résistances avec leurs modules respectifs (14, 40, 50, 51) sont réalisés sous forme de cartes à circuits imprimés selon des techniques dites "PCB".
